Europäisches Patentamt

European Patent Office

Office européen des brevets

(19)

(11) **EP 0 765 845 A1**

(12) **EUROPEAN PATENT APPLICATION**

(43) Date of publication:
02.04.1997 Bulletin 1997/14

(51) Int Cl.⁶: $C03B\ 37/014$, C03B 37/018

(21) Application number: 96306210.4

(22) Date of filing: 28.08.1996

(84) Designated Contracting States:
DE FR GB

(30) Priority: 31.08.1995 US 521778

(71) Applicant: LITESPEC, INC.
Research Triangle Park,
North Carolina 27709 (US)

(72) Inventors:
• Barish, Eric Lee
Raleigh, North Carolina 27615 (US)

• Covington, Michael Ray
Hillsborough, North Carolina 27278 (US)
• Bowden, Hubert Earl
Garner, North Carolina 27529 (US)
• Stearley, Mark Kevin
Cary, North Carolina 27513 (US)

(74) Representative: Johnston, Kenneth Graham et al
Lucent Technologies (UK) Ltd,
5 Mornington Road
Woodford Green Essex, IG8 OTU (GB)

(54) **Method for vapor filtration of impurities during optical fiber preform manufacture**

(57) The present invention generally relates to an improvement in the process for manufacturing optical fibers by drawing a preform made by vapour phase deposition techniques. More specifically, the present invention recognizes and obviates adverse effects on the operational performance of optical fibers manufactured using raw halides, such as silicon tetrachloride $SiCl_4$ (28') and/or germanium tetrachloride $GeCl_4$ (27), which contains excessive levels of metal impurities, such as iron. The description and claims of this application set forth a purification technique whereby the raw halide is purposely filtered (31',33') after being converted to its gaseous state as opposed to its liquid state. In a preferred embodiment of the present invention, it has been found that if carbon-based filters (e.g.®Teflon or polypropylene 3;31',33') are used to filter the vaporized halides, there is even a higher level of purification obtained. Although the preferred embodiment of the present invention described herein is directed to the vapor axial deposition (VAD) process, it is understood to be equally applicable and beneficial to other optical fiber manufacturing processes, such as the outside vapor deposition (OVD) method or the modified chemical vapor deposition (MCVD) method.

FIG. 6

## Description

## Technical Field

This invention relates to a method for vapor filtration of impurities during optical fiber manufacture.

## Background of the Invention

The vapor axial deposition (VAD) process is one of several known methods for making glass preforms from which optical fibers can be drawn. As commonly employed, the first step in the VAD process is to use flame hydrolysis to build-up, or deposit, glass soot in such a way that the interior of a glass soot body, known as a soot boule, is made up of glass soot having a higher refractive index than that of the outer surface portion. Such deposition, and the VAD process in general, are discussed, for example, in the U.S. patent of Kawachi et al., No. 4,345,928, granted August 24, 1982, and which is expressly incorporated by reference herein. Accordingly, the soot boule is then dehydrated and sintered to form a solid cylindrical glass core rod comprising an inner core portion of higher refractive index and an outer portion, sometimes known as a clad portion, of lower refractive index. Next, glass jacket soot of relatively low refractive index is deposited on the glass core rod by flame hydrolysis such that a porous soot boule covers completely the glass core rod. The jacket soot is then sintered, typically in an atmosphere of helium to form with the core rod a single glass preform body. As is pointed out, for example, in the U.S. patent of Ito et al., No. 4,978,378, granted December 18, 1990, after sintering, the preform normally contains trapped helium atoms which may be removed by annealing the preform in an inert atmosphere of a gas having a greater molecular weight than that of helium, typically nitrogen.

Attenuation is a measure of the loss in signal intensity as measured in an optical fiber. In accordance with the present invention, one of the factors affecting the extrinsic attenuation measured at 1.31 $\mu$m is determined by the concentration of metal impurities in the optical fiber. More specifically, metal impurities remaining in liquid silicon tetrachloride $SiCl_4$ are carried over in the vapor state and trapped in the porous soot (core) boule during the consolidation step of processing. In the past, raw material suppliers have used activated carbon to purify the material in its liquid form, but unfortunately, such purification of the raw $SiCl_4$ material in the liquid state does not remove all of the trace metal contaminants. However, it has been found in accordance with the present invention that the further filtration of the $SiCl_4$ material in its gaseous state does produce a significantly enhanced purification. In other words, a preferred embodiment of the present invention describes the removal of iron in gaseous $SiCl_4$ to minimize the amount of $FeCl_3$ in optical fibers thus reducing the loss in signal intensity as measured at 1.31 $\mu$m. Yet another key point of interest is the fact that purification of $SiCl_4$ in the gaseous state using carbon further reduces the attenuation as measured at 1310 nm and extends the lifetime (time before change-out of the filter is required) of the point of use filter.

While a number of different manufacturing techniques, including vapor axial deposition (VAD), modified chemical vapor deposition (MCVD) and outside vapor deposition (OVD) methods have proven to be commercially successful, the price of optical fiber is being driven steadily downward by increasing competitive pressures. Improvements in yield and reductions in the cost of making such fiber are therefore being strenuously pursued. We have found that the resulting optical preforms and optical fibers produced by the VAD method practiced by us, which uses raw halides in the creation of the glass soot boule, can be significantly improved by further filtering or purifying the halides while in their vapor or gaseous state. Specifically, the extrinsic attenuation of the optical fiber and preform manufactured can be substantially enhanced by the removal of additional metal impurities. Any improvement in the ultimate performance characteristics of the optical fiber or fiber preforms or any significant reduction in the time taken to make optical fiber or fiber preforms would constitute a significant advancement to the industry.

## Summary of the Invention

The present invention generally relates to an improvement in the process for manufacturing optical fibers as set forth in the claims of this application

## Brief Description of the Drawing

FIG. 1 is a flow chart showing the method for making optical fiber in accordance with the VAD process of the prior art;
FIG. 2 is a schematic illustration of a method for depositing glass soot to form a soot boule in accordance with the method of FIG. 1;
FIG. 3 is a schematic sectional view of apparatus for dehydrating and consolidating the soot boule made by the apparatus of FIG. 2;
FIG. 4 is a cross section showing part of a glass optical fiber made by the process of FIG. 1;

FIG. 5 is a graph of refractive index versus distance for the optical fiber of FIG. 4; and
FIG. 6 is a schematic illustration of the further purification system of the present invention.

## Detailed Description

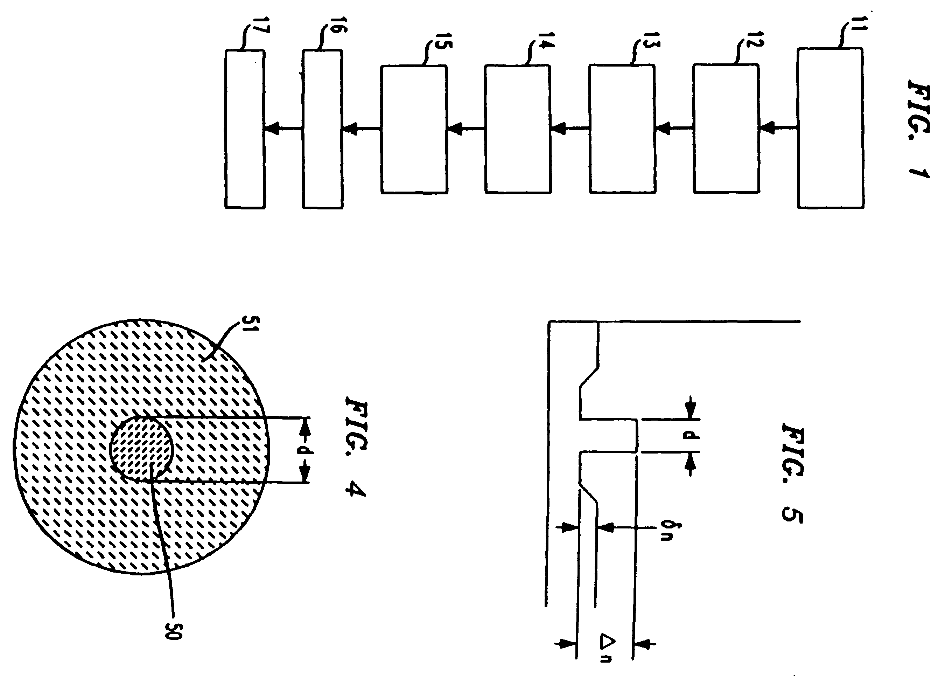

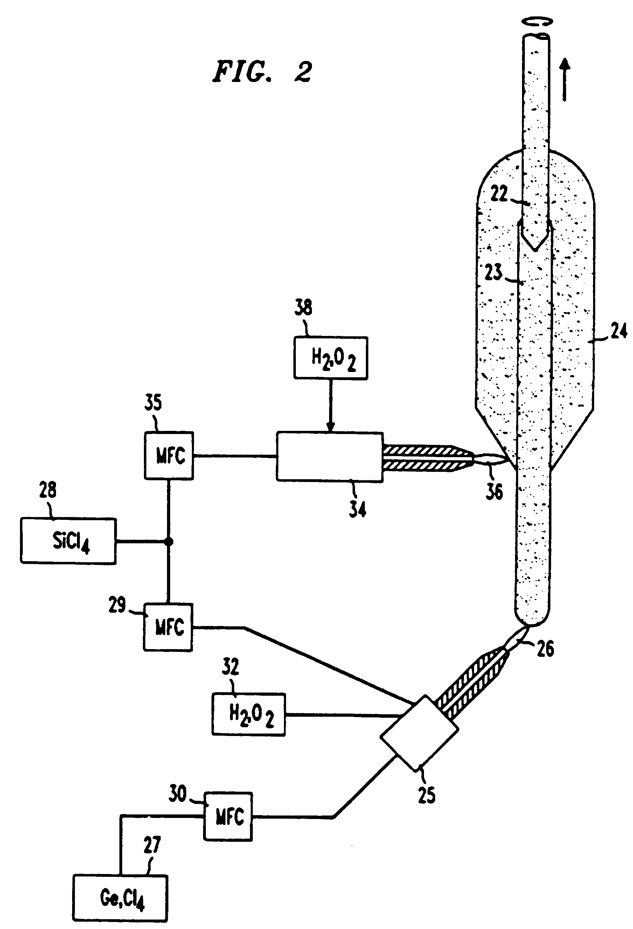

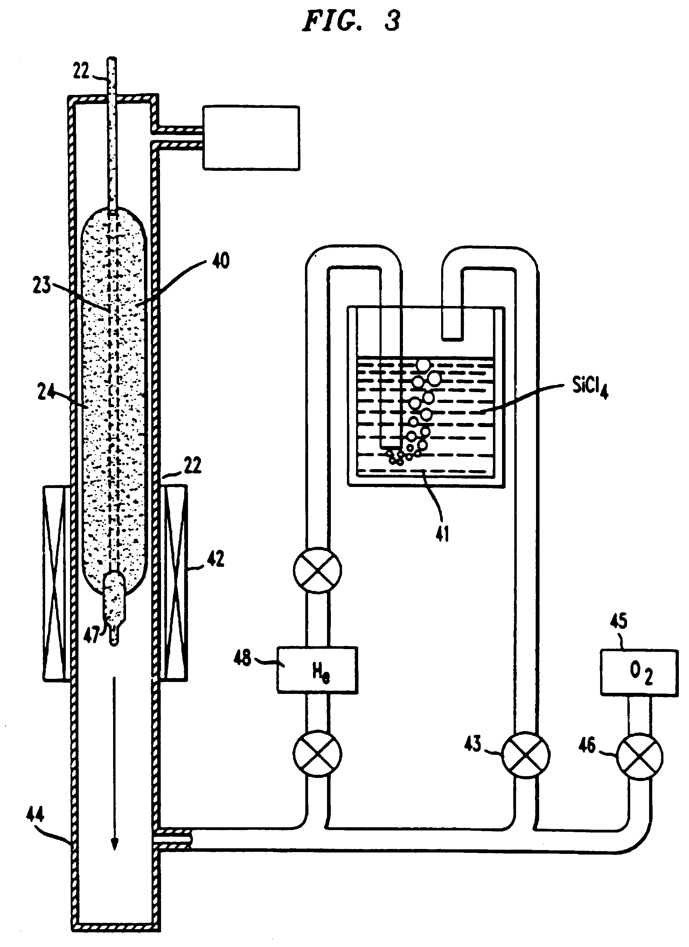

Referring now to FIG. 1, the first step in making optical fiber in accordance with the prior art vapor axial deposition (VAD) process is the step 11 of depositing glass soot on a glass seed element or substrate. This is done by the flame hydrolysis method, illustrated in FIG. 2, in which a pair of burners or torches project vaporized raw halide material to cause glass particles or soot to collect on the seed element by thermophoresis. Additionally, the present invention is particularly directed at improving the results of this step within the optical fiber manufacturing process. In step 12 of the process depicted in Fig. 1, the glass soot boule made by the apparatus of FIG. 2 is then dehydrated. In step 13, the soot boule is consolidated or sintered in a furnace. FIG. 3 illustrates apparatus for performing both the dehydration step 12 and the consolidation step 13. In step 14, glass jacket soot is deposited on the preform portion by the flame hydrolysis method to increase the diameter of the clad portion of the glass preform. In step 15, the jacket glass is consolidated and annealed; in step 16, the preform is elongated; and in step 17, glass fiber is drawn from the preform.

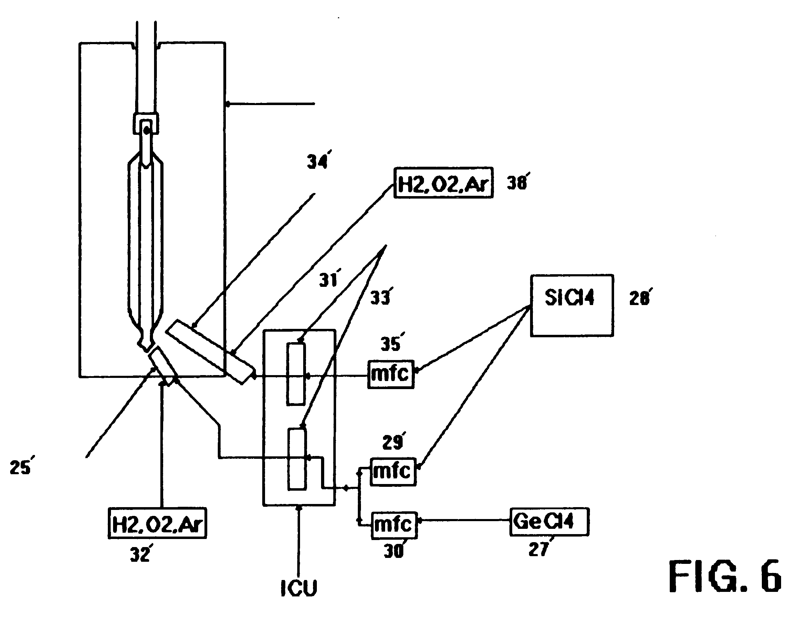

Referring to FIG. 2, and as also shown in FIG. 6, core glass soot 23 is first deposited on a glass seed element or substrate 22 by using a core burner 25 to project raw material within a flame 26. In accordance with the preferred embodiment of the present invention describing the VAD process, the raw material may comprise germanium tetra-chloride $GeCl_4$ from a source 27 and silicon tetrachloride $SiCl_4$ from a source 28. The raw materials are applied through mass flow controllers 29 and 30, known forms of valves and/or delivery units. Fuel comprising hydrogen, oxygen and/or argon from a source 32 is applied with the silicon tetrachloride $SiCl_4$ to the core burner 25.

Concurrently with the deposition of core glass soot 23, a glass clad soot 24 is deposited over the core soot 23 by a burner 34 which applies raw material from source 28 via a mass flow controller 35 through a flame 36. Hydrogen, oxygen and argon maybe supplied from source 38 as fuel for the flame 36. The reason for using two burners for separately applying core glass 23 and clad glass 24 is to provide a core region 23 having a higher refractive index (due to the presence of germanium) than the refractive index of a clad region 24 which is composed entirely of silicon and oxygen (i.e., $SiO_2$), without any germanium. The seed element 22 rotates and moves vertically upwardly during deposition so that region 23 is cylindrical, surrounded by region 24, which is annular. The patent of Kawachi et al., No. 4,345,928, granted August 24, 1982, and expressly incorporated by reference herein, describes various embodiments of the above process in more detail.

It is the improvement of the resulting core glass soot 23 and glass clad soot 24 that is the focus of the present invention. In particular, the present invention describes and claims an enhanced purification of the raw materials, such as halides germanium tetrachloride $GeCl_4$ and/or silicon tetrachloride $SiCl_4$. Furthermore, the optical preforms manufactured with the further purified materials, as well as the optical fibers drawn therefrom, are also set forth herein. However, prior to reciting in more detail the features and attributes of the present invention, it may be more beneficial to essentially complete the discussion of one of the manufacturing processes into which the present invention may be employed.

Now returning to the sequential discussion of the optical fiber manufacturing process, as illustrated in FIG. 3 the core glass 23 and clad glass 24 together constitute a soot boule 40 which can be heated by lowering it through a furnace 42, as shown by the arrow. The boule is first dehydrated by directing vaporized dehydrating gas, such as chlorine $Cl_2$ or silicon tetrachloride $SiCl_4$, from a source 41 through the vessel 44 enclosing the boule. In the preferred embodiment of the present application, pure chlorine gas is flowed through the vessel 44 for dehydration. Chlorine is desired in accordance with the present application since it is easier to process, and to maintain quality control of, than silicon tetrachloride. Additionally, no separate carrier gases are required to manipulate chlorine as is often used with silicon tetrachloride.

However, as disclosed in commonly assigned U.S. patent application serial number 08/344,311 (Covington et al.) silicon tetrachloride $SiCl_4$ may be the dehydration gas of choice. In such applications where silicon tetrachloride is used as the dehydration gas, the vaporized silicon tetrachloride is formed by directing helium from a source 48 through liquid silicon tetrachloride 41. The helium thereafter acts as a carrier for the vaporized silicon tetrachloride, which is directed through a valve 43 into the vessel 44. Oxygen from source 45 is also directed into the vessel via a valve 46. Regardless of the particular dehydration gas selected, the remaining processing steps described below are unchanged.

During dehydration, the glass soot boule 40 may be lowered through the furnace 42 at a speed of typically about four to twelve millimeters per minute. The temperature provided by the furnace 42 is below the transition temperature of glass, and is therefore insufficient to cause any sintering or flowing of the glass boule 40, preferably between about one thousand (1000 °C) and about one thousand three hundred degrees Centigrade (1300 °C). In one typical example, the outer diameter of the soot boule 40 was about one hundred fifty-five millimeters (155 mm), and its length was about eight hundred fifty millimeters (850 mm). The boule was lowered through the furnace at about ten millimeters per minute at a temperature of about one thousand seventy degrees Centigrade (1070 °C). When pure chlorine is used as the dehydration gas, it is flowed past the boule at a rate of approximately 1 liter per minute under present manufacturing speeds. However, in application using silicon tetrachloride as the dehydration gas, gases are flowed past the boule at the following rates: helium, fifteen liters per minute; silicon tetrachloride, 0.15 liters per minute; oxygen ($O_2$) 0.1 liters per minute. The chlorine or silicon tetrachloride removes $H_2O$ molecules and hydroxyl (OH) radicals from the soot boule 40 by reacting with them to form $SiO_2$ and HCl which are removed at the exhaust. Additionally, oxygen ($O_2$) is also removed in processes which used silicon tetrachloride as the dehydration gas. The applied heat speeds up the dehydration reaction.

After dehydration, the soot boule is consolidated or sintered by heating it to a temperature above the transition temperature in an atmosphere that is free of silicon tetrachloride and oxygen. After the silicon tetrachloride and oxygen have been flushed from vessel 44, helium from source 48 is directed through the vessel at a flow rate of about one to fifty liters per minute. Soot boule 40 is lowered through the furnace 42 at a speed of about one to five millimeters per minute at a temperature of about one thousand four hundred fifty (1450 °C) to about one thousand seven hundred degrees Centigrade (1700 °C). This causes the boule to consolidate and to shrink, as illustrated by glass portion 47. It is to be emphasized the glass portion 47 is not formed until after the dehydrating step has been completed, and is shown in FIG. 3 merely to give the reader an appreciation of the shrinking of the soot boule 40 during the consolidation process.

After consolidation, the remainder of the process proceeds as is generally described in FIG. 1. Because these steps conform to the prior art, they will not be reviewed in detail.

FIG. 4 illustrates a cross-sectional view of a typical optical fiber after being drawn from a preform. FIG. 5 illustrates the refractive index along a cross-sectional distance of the fiber. The fiber comprises a core region 50 surrounded by a clad region 51. The core region 50 has a diameter d which is appropriate for giving single-mode propagation, typically eight microns. For purposes of distinguishing single mode from multimode, multimode optical fiber may be considered to have a core diameter d of greater than twenty microns, while single-mode fiber has a diameter d of less than twenty microns. The refractive index in the core is greater than the refractive index in the clad region by an amount $\Delta n$ which, in the case of single-mode fiber is about 0.35 percent of the refractive index of the clad material, whereas for multimode fiber, it is typically one to two percent of the index of refraction of the clad region. Thus, for purposes of distinguishing, single-mode fiber can be said to have a fraction $\frac{\Delta n}{n}$ of less than one percent, where n is the refractive index of the clad material and $\Delta n$ is the difference of the core and clad refractive indices.

Having described one of the optical fiber manufacturing processes, namely VAD, that may employ the present invention, the particulars of the present invention will now be discussed in more detail. The present invention relates to the further purification of the raw halide silicon tetrachloride $SiCl_4$ and/or the germanium tetrachloride $GeCl_4$ used in the manufacture of optical fiber. As noted above, such raw halides are often used to deposit the core glass soot 23 and/or the glass clad soot 24. Most importantly, the present invention recognizes and teaches that the operational performance of the resulting optical fibers is significantly enhanced if the purification level of the raw halides can be ensured to be high. The Applicants have realized that there often exist unacceptably high levels, i.e. greater than about 20 ppb total metals, of metal impurities in the raw halides presently being manufactured and supplied in accordance with standard industry procedures. More specifically, it has been determined 1) that such high levels of metal impurities are not "processed out" by the subsequent optical fiber manufacturing steps and therefore are present in the resulting optical product and 2) that the presence of such high levels of impurities in the resulting optical fiber adversely effects the attenuation characteristics of that fiber, particularly at 1310 nm.

With particular attention to the optical fiber manufacturing process described above, it should be noted that the metal impurities present within the liquid halides, whether it be silicon tetrachloride $SiCl_4$ and/or the germanium tetrachloride $GeCl_4$, are transported in the halide vapor stream, through the torch assemblies, 25 and 34, and ultimately into the porous soot boule 40. Furthermore, once such levels of metal impurities are present within the glass soot boule 40, it is essentially impossible to remove an adequate amount of the impurities from the soot boule during the dehydration step and/or the consolidation step shown as elements 12 and 13 of Fig. 1, respectively. As stated, the attenuation characteristics of an optical fiber may be unacceptably high if such metal impurities are not properly filtered out during the manufacturing process. As is known and accepted throughout the industry, unacceptably high attenuation may render an optical fiber inoperable within the desired telecommunication system.

FIG. 6 depicts the preferred embodiment of the present invention. To overcome the deficiencies set forth above, the present invention further purifies the raw halides, in the specific manufacturing process described above both silicon tetrachloride $SiCl_4$ and/or the germanium tetrachloride $GeCl_4$, while they are in their vapor/gaseous state before either are converted into $SiO_2$ and/or $GeO_2$ particles in process torches 25' and 34' as described earlier. Any known technique for converting the raw halides from their liquid state into their gaseous state is acceptable in accordance with the present invention. However, it should be noted that such conversion may be expedited by pressurizing the unit containing the liquid halide with an inert gas. Additionally, once in its gaseous state, the halide materials may be passed through heated piping, often stainless steel, to maintain the vapor state of the material. In accordance with the processing steps described above, the gaseous halides are moved into the hydrogen/oxygen/argon torches, 25' and 34' where the silicon tetrachloride is converted into $SiO_2$ particles as a result of the reaction between the hydrogen, oxygen and/or argon in the torch. Additionally, the germanium tetrachloride $GeCl_4$ is converted into $GeO_2$ as it contacts the substrate surface.

To further purify the halide materials in accordance with the present invention requires additional treatment of the halide materials before they are deposited onto the rotating seed rod 22'. In the preferred embodiment of the present invention, a modified interconnect unit (ICU) 50 is positioned upstream of at least one of the hydrogen/oxygen/argon torches, 25' and 34', to trap the metal impurities present in the vapor stream. The metal impurities are thereby prohibited from reaching the torches which would apply them to the glass soot boule 40'. In particular, the interconnect unit 50 of the present invention contains at least one Teflon® or polypropylene filter, 31' and 33', within the flowpath of the silicon tetrachloride $SiCl_4$ and/or the germanium tetrachloride $GeCl_4$. As presently designed there is at least one filter, 31' and/or 33', utilized for each torch, 25' and 34' respectively, with each filter having a Teflon® media with a polypropylene or Teflon® housing.

The impurities or contaminants are removed from the vapor stream and trapped on the surface of the filter housing and/or within the filter media. By capturing the impurities within the filters 31' and 33', the level of metal impurities carried-through and deposited on the soot boule 22' and thus ending up in the resulting optical preforms and/or optical fibers is significantly reduced. As stated earlier, the present invention recognizes that additional metal impurities can be removed from a material in its gaseous state as compared to filtering of the material in its liquid state.

The data set forth in the Table below sets forth one example which quantifies the effect the enhanced filtering of such impurities as offered by the present invention may have on the operational characteristics, particularly attenuation, of the resulting optical fiber.

| ATTENUATION @ 1310 nm (no vapor filtering) | ATTENUATION @ 1310 nm (with vapor filtering) | FILTER TYPE |
| --- | --- | --- |
| | | |
| 0.38 dB/km | 0.345 dB/km | NON CARBON FILTER |
| 0.38 dB/km | 0.335 dB/km | CARBON FILTER |

The data above was generated by using a common lot of raw halide material to produce two separate runs of optical fiber. In particular, during the manufacture of one run of optical fiber, the raw halide materials were not subjected to any further filtering, whereas the second manufacturing run of optical fiber used the aspects of the present invention to further filter the raw halide materials while in their vapor state prior to their deposition within the soot boule. As can be readily seen from the results, the attenuation characteristics of the fiber manufactured with the filtered raw halide materials are significantly better than those which used the standard supply of halide materials with no additional filtering.

As stated earlier, one design of a filtering arrangement in accordance with the present invention is depicted in Fig. 6. As illustrated, the preferred embodiment positions the filters inside a modified interconnect unit 50. By utilizing this configuration, there is a separate purge for each of the filters, 31' and 33' and/or the process torches, 25' and 34'. Additionally, each filter unit of the preferred embodiment is composed of all Teflon® and is a modular unit so as to be easily replaceable in the event of any problems with the overall filtering system.

In a slightly different embodiment of the present invention, a plurality of filters, and/or filter components, are aligned in series within the flowpath of the vaporous halide material, such as silicon tetrachloride $SiCl_4$ and/or germanium tetrachloride $GeCl_4$. More specifically, it is desired that one of the filters, and/or filter components, contain carbon in a manner that allows the vaporous halide materials to flow through the carbon and then proceed through the remaining filters, and/or filtering components. The subsequent filters act as a particulate filter which traps any carbon carried out of the earlier filters and thereby prohibits the carbon from entering the process torches 25' and 34' and/or the soot boule 22'.

Yet another benefit of the present invention is the ability of such a filtering system to significantly reduce the amount of impurities that are transported into the dehydration and consolidation furnace. If a high concentration of metals are carried into the furnace(s) either in or on the porous soot boule, some of these impurities or contaminants will become separated from the soot boule and attach themselves to the interior walls of the furnace vessel during its cool down period. Unfortunately, separated impurities may become airborne during the subsequent heating and reattach themselves to the next soot boule being processed in that furnace. Therefore, under such a situation, even while later processing a soot boule which truly contains less impurities, there is substantial possibility that this acceptably clean soot may in fact become contaminated due to its placement into a "contaminated furnace vessel."

The various embodiments described are intended to be merely illustrative of the principles of the invention. The invention may be used in processes other than the VAD method, for example, the known outside vapor deposition (OVD) method or the modified chemical vapor deposition (MCVD) method as well as any other industry accepted optical manufacturing technique that processes such raw halides or the like. In some circumstances, it may be desirable to use the invention to further filter "jacket glass" in accordance with step 14 of FIG. 1. Various other embodiments and modifications may be made by those skilled in the art without departing from the spirit and scope of the invention.

## Claims

1. A method for making optical fiber comprising the steps of: making a soot boule which includes a raw halide material by depositing, over core glass of a first refractive index, clad glass soot of a second refractive index that is lower than the first refractive index; dehydrating said soot boule comprising the step of heating the soot boule to a temperature below its transition temperature while exposing it to a dehydrating atmosphere; consolidating said soot boule by heating the soot boule to a temperature above its transition temperature; making from said consolidated glass an optical fiber preform; and drawing from said preform optical fiber; wherein the improvement is characterized in that:
   said halide material is filtered while in its gaseous state prior to being deposited to make the soot boule.

2. The method of claim 1 wherein:
   the filtered halide material is present in the core glass portion of the soot boule.

3. The method of claim 1 wherein:
   the filtered halide material of the soot boule is present in the clad glass soot portion.

4. The method of claim 1 wherein:
   the halide material is exposed to carbon during its filtering.

5. The method of claim 1 wherein:

   the difference of the refractive index of the core glass and the refractive index of the clad glass, $\Delta n$, is less than one percent of the refractive index of the clad glass;
   and said optical fiber is suitable for propagating single-mode lightwaves.

6. The method of claim 1 wherein:

   the step of making the soot boule comprises the step of simultaneously depositing core glass soot and clad glass soot;
   and the consolidating step comprises the step of simultaneously consolidating core glass and clad glass.

7. The method of claim 1 wherein:
   said steps comprise the VAD method for making optical fiber.

8. The method of claim 1 wherein:
   said steps comprise the OVD method for making optical fiber.

9. The method of claim 1 wherein:
   said steps comprise the MCVD method for making optical fiber.

10. A method for making optical fiber preform comprising the steps of: making a soot boule which includes a raw halide material by depositing, over core glass of a first refractive index, clad glass soot of a second refractive index that is lower than the first refractive index; dehydrating said soot boule comprising the step of heating the soot boule to a temperature below its transition temperature while exposing it to a dehydrating atmosphere; consolidating said soot boule by heating the soot boule to a temperature above its transition temperature; and making from said consolidated glass an optical fiber preform; wherein the improvement is characterized in that:
    said halide material is filtered while in its gaseous state prior to being deposited to make the soot boule.

*FIG. 1*

*FIG. 5*

*FIG. 4*

# FIG. 2

# FIG. 3

EP 0 765 845 A1

34´

H2,O2,Ar   38´

31´

33´

SiCl4   28´

35´

mfc

25´

29´

mfc

H2,O2,Ar

32´

mfc   GeCl4

30´   27´

ICU

FIG. 6

EP 0 765 845 A1

**European Patent Office**

## EUROPEAN SEARCH REPORT

Application Number

EP 96 30 6210

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 2, no. 51 (E-26), 12 April 1978 & JP-A-53 013438 (SUMITOMO ELECTRIC IND. CO. LTD.), 7 February 1978, | 1-4,9,10 | C03B37/014 C03B37/018 |
| Y | * abstract * | 5-7 | |
| D,Y | US-A-4 345 928 (M.KAWACHI ET AL.) * column 12, line 41 - column 13, line 25 * | 5-7 | |
| X | US-A-4 212 663 (M.A.ASLAMI) * figure 2 * | 1,8,10 | |
| A | PATENT ABSTRACTS OF JAPAN vol. 16, no. 30 (M-1203), 24 January 1992 & JP-A-03 239900 (M.SHUNICHI ), 25 October 1991, * abstract * | 1,10 | |
| A | GB-A-2 057 423 (SIEMENS AG) * abstract; figures 1,2 * | 1,10 | TECHNICAL FIELDS SEARCHED (Int.Cl.6) C03B C23C |

The present search report has been drawn up for all claims

| Place of search | Date of completion of the search | Examiner |
|---|---|---|
| THE HAGUE | 3 December 1996 | Stroud, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)